(19) Europäisches Patentamt
European Patent Office
Office européen des brevets

(11) **EP 4 440 054 A1**

(12) **EUROPEAN PATENT APPLICATION**

(43) Date of publication:
**02.10.2024 Bulletin 2024/40**

(51) International Patent Classification (IPC):
**H04L 25/02** *(2006.01)*    **H04L 25/49** *(2006.01)*

(21) Application number: **23217621.4**

(22) Date of filing: **18.12.2023**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **31.03.2023 US 202318129138**

(71) Applicant: **Intel Corporation**
**Santa Clara, CA 95054 (US)**

(72) Inventors:
• **HECK, Howard**
  **Tigard, OR Oregon (US)**
• **JAIN, Amit**
  **Sherwood, OR Oregon 97140 (US)**
• **MASON ORITZ, Marva**
  **Santa Clara, 95054 (US)**
• **HAILU, Eskinder**
  **Santa Clara, 95054 (US)**
• **HALL, Stephen**
  **Middleton, ID Idaho 83644 (US)**
• **KUAN, Chin Lee**
  **Bentong, 28700 (US)**
• **SHEKHAR, Sameer**
  **Portland, OR Oregon 97229 (US)**

(74) Representative: **Viering, Jentschura & Partner mbB**
**Patent- und Rechtsanwälte**
**Am Brauhaus 8**
**01099 Dresden (DE)**

(54) **ENCODING DIFFERENTIAL SIGNALS FOR POWER AND NOISE REDUCTION**

(57)    An apparatus, system, and method for improved power consumption and/or noise reduction in a differential input/output (I/O) buffer are provided. A circuit can include a differential signal buffer and encoding scheme quantifying and selection circuitry. The encoding scheme quantifying and selection circuitry can be configured to generate a selection code indicating a selected encoding scheme of the encoding schemes based on respective signals indicating whether each respective encoding scheme of encoding schemes has a net positive power consumption reduction in differential signals. The encoding scheme quantifying and selection circuitry can be configured to provide the selection code to an encoder.

FIG. 2

EP 4 440 054 A1

**Description**

TECHNICAL FIELD

Embodiments pertain to circuitry that reduce power consumption and noise in a differential input/output (I/O) buffer.

BACKGROUND

Power consumption and power supply noise generated by differential I/O buffers varies with the data being transmitted. Data Bus Inversion (DBI) is a commonly used technique for power reduction in signal-ended interfaces where transmitted data bits are inverted based on total power considering all transitions at a clock edge.

BRIEF DESCRIPTION OF THE FIGURES

In the figures, which are not necessarily drawn to scale, like numerals may describe similar components in different views. Like numerals having different letter suffixes may represent different instances of similar components. The figures illustrate generally, by way of example, but not by way of limitation, various embodiments discussed in the present document.

FIG. 1 illustrates, by way of example, voltage diagrams that help explain operation of a DBI power reduction technique.
FIG. 2 illustrates, by way of example, a diagram of an embodiment of a system that includes improved data management.
FIG. 3 illustrates, by way of example, a graph of power savings in an I/O using a selectable encoding scheme.
FIG. 4 illustrates, by way of example, a diagram of an embodiment of a method for power consumption reduction in an I/O buffer using a selectable encoding scheme.
FIG. 5 illustrates, by way of example, a block diagram of an embodiment of a machine (e.g., a computer system) that includes components that can benefit from a selective encoding scheme for a differential signal.

DETAILED DESCRIPTION

The following description and the drawings sufficiently illustrate specific embodiments to enable those skilled in the art to practice them. Other embodiments may incorporate structural, logical, electrical, process, and other changes. Portions and features of some embodiments may be included in, or substituted for, those of other embodiments. Embodiments set forth in the claims encompass all available equivalents of those claims.

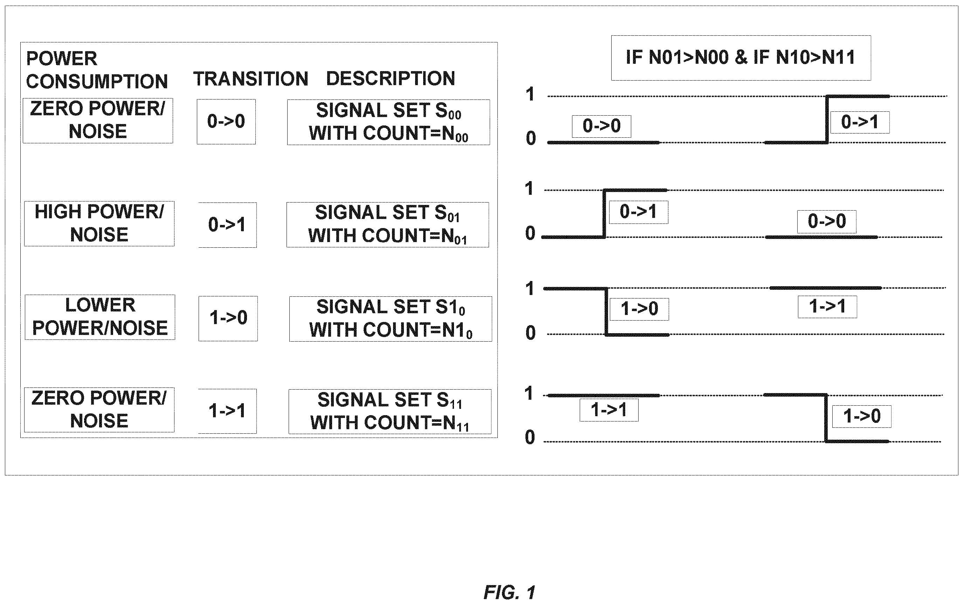

FIG. 1 illustrates, by way of example, voltage diagrams that help explain operation of a DBI power reduction technique. As shown in FIG. 1, there are four possible power consumption levels associated with each data bit transition. A decision to invert one or more bits is made. One or more bits are inverted if the number of transitions with highest power consumption (Setting $S_{01}$, $S_{10}$ transitions from low to high) is greater than the number of transitions with zero power consumption (Sets $S_{00}$ or $S_{11}$). If an inversion condition is satisfied, a DBI signal (Scode) is asserted and data for the entire bus is inverted (encoded) before transmission. At the Receiver device (RX), the encoded data is then inverted again (decoded) based on the DBI signal (Scode) to obtain the original data.

For subsequent discussions Pulse Amplitude Modulation 4-level (PAM4) is used as the differential signal application. Other differential I/O applications can be addressed similarly. Table 1 provides a description of PAM4 voltage and transition power levels.

TABLE 1: normalized power for PAM4 data transitions

|  | Signal Trans. | P Trans. | P Power | N Trans. | N Power | Total Power |
|---|---|---|---|---|---|---|
| G3 | 00->10 | 0->500 | 3 | 500->0 | 0 | 3 |
|  | 10->00 | 500->0 | 0 | 0->500 | 3 | 3 |
| G2 | 00->11 | 0->267 | 2 | 500->133 | 0 | 2 |
|  | 01->10 | 133->500 | 2 | 267->0 | 0 | 2 |
|  | 10->01 | 500->133 | 0 | 0->267 | 2 | 2 |
|  | 11->00 | 267->0 | 0 | 133->500 | 2 | 2 |

(continued)

|  | Signal Trans. | P Trans. | P Power | N Trans. | N Power | Total Power |
|---|---|---|---|---|---|---|
| G1 | 00->01 | 0->133 | 1 | 500->267 | 0 | 1 |
|  | 01->11 | 133->267 | 1 | 267->133 | 0 | 1 |
|  | 01->00 | 133->0 | 0 | 267->500 | 1 | 1 |
|  | 10->11 | 500->267 | 0 | 0->133 | 1 | 1 |
|  | 11->10 | 267->500 | 1 | 133->0 | 0 | 1 |
|  | 11->01 | 267->133 | 0 | 133->267 | 1 | 1 |
| G0 | 00->00 | 0->0 | 0 | 500->500 | 0 | 0 |
|  | 01->01 | 133->133 | 0 | 267->267 | 0 | 0 |
|  | 10->10 | 500->500 | 0 | 0->0 | 0 | 0 |
|  | 11->11 | 267->267 | 0 | 133->133 | 0 | 0 |

Table 1 shows signal data and voltage transitions for one differential signal pair (positive side (P) of the differential lines and negative side (N) of the differential lines) for PAM4. The voltage levels and associated data are one possible representative set, as there is no governing industrial standard. Table 1 shows normalized power consumed with each associated data transition. Note that Table 1 could be augmented to further include noise for each transition as well. The power for P and N signal lines is determined as follows: *no voltage change* → 0 power consumed; *decrease in voltage* → 0 power consumed; *increase in voltage* → positive power consumed; and an amount of power consumed with voltage increases in proportion to increase in voltage. For simple illustration the representative numbers chosen for the normalized power consumed are 0, 1, 2, 3. Actual normalized power consumption depends on specific transmit and receive circuitry and channel characteristics.

For each differential signal pair, the power consumed in transitions on P and N lines are added together to give the total power for the differential pair (sometimes called a "lane"). As expected, some data transitions consume higher power than others. There are sixteen possible transitions for each lane. These sixteen possibilities are sorted in decreasing order of power consumed in Table 1. Thus, the first two rows, where either the P or N line has a voltage increase of 500 mV, have the highest power consumption of all. The last four rows have zero power since the voltage level does not change.

A similar table can be created ordering steady power consumption at the final voltage level instead of the transition itself. This is also known as "termination power". Another ordering can include prioritizing voltage noise generated at each data transition for one differential pair. While the specific schemes below focus on transition power reduction, other schemes for minimizing power delivery noise and power consumption with different termination powers can be derived.

At any given clock edge each lane of the I/O bus undergoes one of sixteen transitions listed in Table 1. Total power consumption for the bus can be estimated by Equation 1:

$$P_{total} = \sum_{i=1,\dots,n} p_i \ \text{Equation 1}$$

where $p_i$ is the power consumption of the $i^{th}$ lane, and $n$ is the number of lanes. Categories G0, G1, G2, and G3 correspond to the total power consumed as listed in Table 1. One can rewrite the total bus power consumed as:

$$P_{total} = \sum_{j=0,1,2,3} P_j N_j \ \text{Equation 2}$$

where the index $j$ denotes the category $G_j$ corresponding to normalized power $P_j$ = 0, 1, 2, 3, and $N_j$ is the number of differential pairs in category $G_j$ at that clock edge. From Table 1, power consumption is minimized by a minimizing number of instances in the higher numbered categories (e.g., G2 and G3).

A power aware scheme can thus include:

1. Logic to determine if and what coding scheme to implement and generate an "Scode" that identifies the coding scheme
2. Encoding logic
3. Transmission of Scode to receiver and
4. Decoding logic based on Scode.

In practice, the logic components benefit from simple implementation. A few specific schemes are included below for illustrative purposes.

Note that Equations 1 and 2 and the power aware scheme can be adjusted to account for noise as well. The power consumed can be weighted and the noise component can be weighted as well. The weights can indicate the relative importance for the noise and power in the overall power reduction and noise reduction scheme. If power is more important, then a higher weight can be used for the power than the noise and vice versa. The logic to determine the encoding scheme to implement in encoding the data can consider both the weighted noise and the weighted power.

A simpler scheme for encoding/decoding involves bit inversions, similar to DBI for single ended signal buses. For differential signals this can take four forms: no bits inverted, 1st bit inversion, 2nd bit inversion, or inversion of both bits. Herein, 1st bit is assumed to be the P bit and the 2nd bit is assumed to be the N bit. Table 2 shows how each of the sixteen possible transitions get modified with bit inversions. Table 2 also shows a corresponding change in normalized power consumption. The positive power saved values indicate power reduction while negative values indicate power increased when applying the scheme. Summing up the power change for each scheme yields zero. This indicates that for a random distribution of data transitions the average power change is zero using any one of the schemes (if applied unconditionally). Thus, the chosen scheme should be selective. The chosen scheme should be used for best power savings given the specific set of transitions at each clock edge.

Table 2: Inversion schemes. B0* and B1* indicate data values at the previous clock edge, B0 and B1 indicate the data values to be transmitted at the next clock edge; B0 & B1 may be inverted using the inversion scheme or without any inversion.

| | Original Transition | | | | 1st Bit Inversion | | | 2nd Bit Inversion | | | Both Bits Inverted | | |
|---|---|---|---|---|---|---|---|---|---|---|---|---|---|
| k | B0* | B1* | B0 | B1 | B0 | B1 | PWR Saved | B0 | B1 | PWR Saved | B0 | B1 | PWR Saved |
| 1 | 0 | 0 | 1 | 0 | 0 | 0 | 3 | 1 | 1 | 2 | 0 | 1 | 2 |
| 2 | 1 | 0 | 0 | 0 | 1 | 0 | 3 | 0 | 1 | 2 | 1 | 1 | 2 |
| 3 | 0 | 1 | 1 | 0 | 0 | 0 | 1 | 1 | 1 | 2 | 0 | 1 | 2 |
| 4 | 1 | 1 | 0 | 0 | 1 | 0 | 1 | 0 | 1 | 2 | 1 | 1 | 2 |
| 5 | 0 | 0 | 0 | 1 | 1 | 1 | -1 | 0 | 0 | -2 | 1 | 0 | -2 |
| 6 | 0 | 1 | 0 | 0 | 1 | 0 | -1 | 0 | 1 | 0 | 1 | 1 | 0 |
| 7 | 1 | 0 | 1 | 1 | 0 | 1 | -1 | 1 | 0 | -2 | 0 | 0 | -2 |
| 8 | 1 | 1 | 1 | 0 | 0 | 0 | -1 | 1 | 1 | 0 | 0 | 1 | 0 |
| 9 | 0 | 0 | 1 | 1 | 0 | 1 | 1 | 1 | 0 | 2 | 0 | 0 | 2 |
| 10 | 1 | 0 | 0 | 1 | 1 | 1 | 1 | 0 | 0 | 2 | 1 | 0 | 2 |
| 11 | 0 | 1 | 1 | 1 | 0 | 1 | 1 | 1 | 0 | 0 | 0 | 0 | 0 |
| 12 | 1 | 1 | 0 | 1 | 1 | 1 | 1 | 0 | 0 | 0 | 1 | 0 | 0 |
| 13 | 0 | 0 | 0 | 0 | 1 | 0 | -3 | 0 | 1 | -2 | 1 | 1 | -2 |
| 14 | 0 | 1 | 0 | 1 | 1 | 1 | -1 | 0 | 0 | -2 | 1 | 0 | -2 |
| 15 | 1 | 0 | 1 | 0 | 0 | 0 | -3 | 1 | 1 | -2 | 0 | 1 | -2 |
| 16 | 1 | 1 | 1 | 1 | 0 | 1 | -1 | 1 | 0 | -2 | 0 | 0 | -2 |

A generic condition for encoding, independent of encoding scheme, is described by Equation 3:

$$\Delta P_{total} = \sum_{k=1,2,\cdots 16} \Delta P_k N_k \quad > 0 \text{ Equation 3}$$

Where $\Delta P_k$ is the change in power for each transition $k$ and $N_k$ is the number of signal pairs undergoing transition k at the given clock edge. Weaker, suboptimal conditions can be derived for simpler implementations.

For the three schemes of Table 2, equations (4)-(6) below are sufficient to ensure a reduction in power consumption. These suboptimal conditions can be implemented with combinatorial logic alone and do not require computations for the generic condition of Equation 3.

$$1^{st} \text{ Bit: } \sum_{k=1,2} N_k \; > \sum_{k=13,15} N_k \; \& \; \sum_{k=2,4,9,10,11,12} N_k \; >$$

$$\sum_{k=5,6,7,8,14,15} N_k \text{ Equation 4}$$

2nd Bit:

$$\sum_{k=1,2,\ldots,8} N_k \; > \sum_{k=9,10,\ldots,16} N_k \quad \text{Equation 5}$$

Both Bits:

$$\sum_{k=1,2,3,4,9,10} N_k \; > \sum_{k=5,7,13,14,15,16} N_k \text{ Equation 6}$$

Table 3 describes logic to determine when a signal pair is in a state that would save power with the coding scheme. The simplest logic is for the scheme that includes inversion of both bits, where the condition (per lane) that will save power is: XB = B0* & B0* | ~B0* & B0*. If the number of lanes that satisfy this condition is greater than the number of lanes that do not, inversion of both bits results in power reduction for the entire bus at that clock edge.

For 1st bit Inversion, the logic to categorize each lane for power reduction (= 1 or 3) or increase (=-1 or -3) with this scheme is stated by the expressions for YP1, YP3, YN1, and YN3, respectively. Counting the number of lanes in each category one can then check the weaker conditions of Equation 4 to determine if the entire bus will benefit from this coding.

For 2nd bit inversion, the variable X2 = 1 indicates if the differential pair will save power with this encoding. For the entire bus, one can count the number differential pairs that save power and compare with the number of different pairs that do not, i.e., check the condition in Equation 5.

Table 3: Logic to Determine when bit inversion will provide power benefit. The rows of Table 3 are consistent and additional to the rows of Table 2. That is, the entries of the row k=3, for example, in Table 2 are add-ons to Table 3.

| | Original Transition | | | | 1st Bit Inversion | | | 2nd Bit Inversion | | Both Bits Inverted | |
|---|---|---|---|---|---|---|---|---|---|---|---|
| K | B0* | B1* | B0 | B1 | $\Delta P$ | $Y_{P1}$ | $Y_{P3}$ | $\Delta P$ | X2 | $\Delta P$ | XB |
| 1 | 0 | 0 | 1 | 0 | 3 | 0 | 1 | 1 | 1 | 2 | 1 |
| 2 | 1 | 0 | 0 | 0 | 3 | 0 | 1 | 1 | 1 | 2 | 1 |
| 3 | 0 | 1 | 1 | 0 | 1 | 1 | 0 | 1 | 1 | 2 | 1 |
| 4 | 1 | 1 | 0 | 0 | 1 | 1 | 0 | 1 | 1 | 2 | 1 |
| 5 | 0 | 0 | 0 | 1 | -1 | 0 | 0 | 1 | 1 | -2 | 0 |
| 6 | 0 | 1 | 0 | 0 | -1 | 0 | 0 | 1 | 1 | 0 | X |
| 7 | 1 | 0 | 1 | 1 | -1 | 0 | 0 | 1 | 1 | -2 | 0 |
| 8 | 1 | 1 | 1 | 0 | -1 | 0 | 0 | 1 | 1 | 0 | X |
| 9 | 0 | 0 | 1 | 1 | 1 | 1 | 0 | 0 | 0 | 2 | 1 |
| 10 | 1 | 0 | 0 | 1 | 1 | 1 | 0 | 0 | 0 | 2 | 1 |
| 11 | 0 | 1 | 1 | 1 | 1 | 1 | 0 | 0 | 0 | 0 | X |

(continued)

| | Original Transition | | | | 1st Bit Inversion | | | 2nd Bit Inversion | | Both Bits Inverted | |
|---|---|---|---|---|---|---|---|---|---|---|---|
| K | B0* | B1* | B0 | B1 | ΔP | $Y_{P1}$ | $Y_{P3}$ | ΔP | X2 | ΔP | XB |
| 12 | 1 | 1 | 0 | 1 | 1 | 1 | 0 | 0 | 0 | 0 | X |
| 13 | 0 | 0 | 0 | 0 | -3 | 0 | 0 | 0 | 0 | -2 | 0 |
| 14 | 0 | 1 | 0 | 1 | -1 | 0 | 0 | 0 | 0 | -2 | 0 |
| 15 | 1 | 0 | 1 | 0 | -3 | 0 | 0 | 0 | 0 | -2 | 0 |
| 16 | 1 | 1 | 1 | 1 | -1 | 0 | 0 | 0 | 0 | -2 | 0 |

For 1st bit inversion:

$$Y_{P1} = B0 \ \& \sim B0^* \ \& \ B1 \ OR \sim B0 \ \& \ B0^* \ \& \ B1^* \ OR \ B0 \ \& \sim B0^* \ \& \sim B1^*$$

$$OR \sim B0 \ \& \sim B0^* \ \& \sim B1 \ \& \sim B1^*$$

$$Y_{P3} = \sim B1 \ \& \sim B1^* \ \& \ (B0 \ \& \sim B0^* \ OR \sim B0 \ \& \ B0^*)$$

$$Y_{N1} = B0 \ \& \ B0^* \ \& \ B1^* \ OR \sim B0 \ \& \sim B0^* \ \& \sim B1^* \ OR \sim B0 \ \& \sim B1 \ \& \ B1^*$$

$$OR \ B0 \ \& \ B0^* \ \& \ B1 \ \& \sim B1^*$$

$$Y_{N3} = \sim B1 \ \& \sim B1^* \ \& \ (\sim B0 \ \& \sim B0^* \ OR \ B0 \ \& \ B0^*)$$

For 2nd bit inversion:

$$X2 = B0 \ \& \sim B0^* \ \& \sim B1 \ OR \sim B0 \ \& \ B0^* \ \& \sim B1 \ OR \sim B0 \ \& \sim B0^* \ \& \ B1 \ \&$$

$$\sim B1^* \ OR \sim B0 \ \& \sim B0^* \ \& \sim B1 \ \& \ B1^* \ OR \ B0 \ \& \ B0^* \ \& \ B1$$

Note that the different bit inversion schemes offer benefits for different sets of data transitions. Thus, it is possible to get further savings by combining the schemes. When combining schemes (using multiple of the schemes), the code transmitted to the receiver would be more than one bit to indicate which coding scheme is implemented. For example, code "00" indicating no coding, "01" indicating 1st bit inversion, "10" indicating 2nd bit inversion, and "11" indicating inversion of both bits.

Another class of encoding/decoding schemes for power reduction includes performing a predetermined swapping of transitions. Table 4 shows how each of the sixteen possible transitions can get modified by swapping the original data transition from highest power consumption to the lowest possible power consumption. For example, swapping the k=1 data transition to the k=13 transition gives the highest power reduction. The same applies for k=2, etc. This table then can be used as a lookup table on the transmit and receive for encoding and decoding.

Table 4: Transition Swap Scheme

| | | Modified | | Power Original | Power Modified | Power Saved |
|---|---|---|---|---|---|---|
| k_original | k_mod | B0 | B1 | | | |
| 1 | 13 | 0 | 0 | 3 | 0 | 3 |
| 2 | 15 | 1 | 0 | 3 | 0 | 3 |
| 3 | 7 | 0 | 1 | 2 | 1 | 1 |

(continued)

| k_original | k_mod | Modified | | Power Original | Power Modified | Power Saved |
| --- | --- | --- | --- | --- | --- | --- |
| | | B0 | B1 | | | |
| 4 | 14 | 0 | 1 | 2 | 0 | 2 |
| 5 | 10 | 1 | 1 | 2 | 1 | 1 |
| 6 | 16 | 1 | 1 | 2 | 0 | 2 |
| 7 | 3 | 1 | 1 | 1 | 2 | -1 |
| 8 | 9 | 0 | 0 | 1 | 1 | 0 |
| 9 | 4 | 1 | 0 | 1 | 2 | -1 |
| 10 | 2 | 0 | 0 | 1 | 3 | -2 |
| 11 | 12 | 0 | 1 | 1 | 1 | 0 |
| 12 | 6 | 0 | 0 | 1 | 2 | -1 |
| 13 | 1 | 1 | 0 | 0 | 3 | -3 |
| 14 | 8 | 1 | 1 | 0 | 1 | -1 |
| 15 | 5 | 0 | 1 | 0 | 2 | -2 |
| 16 | 11 | 1 | 0 | 0 | 1 | -1 |

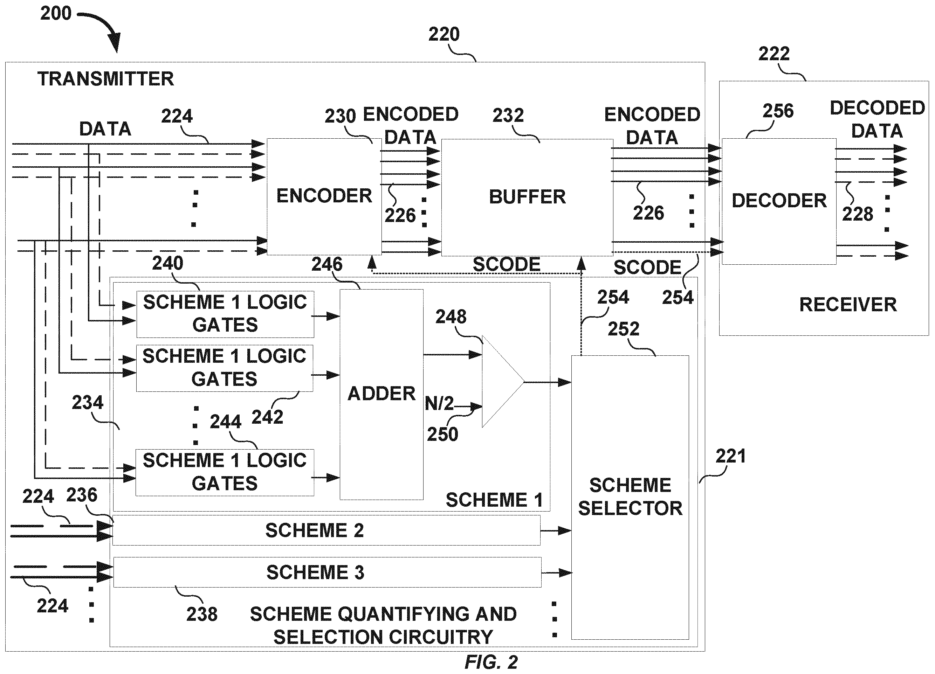

FIG. 2 illustrates, by way of example, a diagram of an embodiment of a system 200 that includes improved data management. Since different encoding schemes offer benefits for different sets of data transitions, further savings are possible by combining the schemes. The system 200 in FIG. 2 provides for the possibility of using different encoding schemes on data. When combining schemes, the code ("Scode") that indicates the encoding scheme is transmitted to the receive device. The Scode in such examples is more than one bit to indicate which coding scheme is implemented. For example, code "00" indicating no coding, "01" indicating 1st bit inversion, "10" indicating 2nd bit inversion, and "11" indicating inversion of both bits. Another possibility is to make Scode three bits and let 000 indicate no coding, 001 indicate 1st bit inversion, 010 indicate 2nd bit inversion, 011 indicate inversion of both bits, and 1XX indicate a swap scheme is used (a scheme in accord with Table 4, for example).

The system 200 as illustrated includes a transmitter220 and a receiver222. The transmitter 220 encodes data 224, received in the form of differential signals, and transmits the data in encoded form as encoded data 226. The receiver 222 receives the encoded data 226. The receiver 222 decodes the encoded data 226 to recover decoded data 228. The decoded data 228 equals the data 224 from the transmitter 220.

The transmitter 220 includes an encoder 230 and data buffers 232 (differential signal buffer).The transmitter 220 includes encoding scheme quantifying and selection circuitry 221. The encoding scheme quantifying and selection circuitry 221, as illustrated, includes scheme quantifying logic 234, 236, 238 and a scheme selector 252, sometimes called "scheme selection circuitry". The respective scheme quantifying logic 234, 236, 238 provides a value indicating a benefit provided from using a respective encoding scheme on the data 224. The encoding schemes discussed thus far are (i) no encoding, (ii) 1st bit inversion, (iii) 2nd bit inversion, (iv) both bit inversion, and (v) swap table encoding. Each scheme quantifying logic 234, 236, 238 includes logic gates (e.g., AND, OR, XOR, negate, buffer, or the like) that are configured to determine whether a given bit pair of the data 224 will benefit from the encoding scheme. The quantifying logic 234, 236, 238 can further determine a number of the lanes of the data 224 that will benefit from the encoding scheme. The number can be an integer greater than, or equal to, zero.

The quantifying logic 234 as illustrated includes logic gates 240, 242, 244 that detect whether a given criterion is satisfied by the data 224. The quantifying logic 236, 238 can have logic gates that detect whether a different encoding scheme, than the one detected by the quantifying logic 234, will benefit the data 224. The criterion are the logic statements that determine whether the given encoding scheme will benefit the data 224 based on the transition on the given lane. The logic gates 240, 242, 244 can each detect the conditions that will benefit an encoding scheme. For example, the logic gates 240, 242, 244 can detect whether a given lane of the data 224 will benefit from encoding using a 1st bit inversion, the logic gates 240, 242, 244 will benefit from encoding using a 2nd bit inversion, or the logic gates 240, 242, 244 will benefit from encoding by inverting both bits. The quantifying logic 234 can thus detect whether the data 224 will benefit from a type of bit inversion, swapping, or other encoding scheme. The quantifying logic 234 can further provide a value that indicates an amount that the data 224 will benefit from the given bit inversion scheme. A higher integer value can indicate more benefit from the inversion scheme.

An adder 246 can add the number of logic gates 240, 242, 244 that indicate that the data lane will benefit from the encoding scheme (or equivalent). Compare logic 248 can determine whether more than half of the data lanes will benefit from the encoding scheme. The compare logic 248 can compare the result from the adder 246 to half the number of data lanes (N is the number of data lanes, so N/2 250 is half the number of data lanes). The compare logic 248 can provide a value to the scheme selector 252 that indicates whether the encoding scheme has a net benefit on the data 224, a value indicating an amount of benefit the encoding scheme has on the data 224, a combination thereof, or the like.

The scheme selector 252 receives output from the quantifying logic 234, 236, 238 (the value to the scheme selector 252 that indicates whether the encoding scheme has a net benefit on the data 224, a value indicating an amount of benefit the encoding scheme has on the data 224, or a combination thereof). The scheme selector 252 selects an encoding scheme that has a net power benefit on the data 224. The scheme selector 252 can select the first scheme, in a hierarchy of schemes, that has a benefit on the data 224, the scheme that has the highest benefit on the data 224, or can select the scheme based on some other heuristic. The scheme selector 252 generates an scode 254 that indicates which encoding scheme to use to encode the data 224.

The encoder 230 receives the scode 254 and encodes the data 224 based on the scheme indicated by the scode 254. An output of the encoder 230 is encoded data 226. Encoded data 226 is the data 224 altered in accord with the encoding scheme indicated by the scode 254.

The buffer 232 is an electronic circuit element used to isolate the encoded data 226 from the receive device 222. The buffer 232 receives the encoded data 226 and the scode 254. The buffer 232 provides the encoded data 226 and the scode 254 to the receive device 222. The input impedance of the buffer 232 is relatively high compared to the impedance of the receive device 222. The buffer 232 draws very little current so as to avoid disturbing the encoded data 226. The buffer 232 is sometimes called a unity gain buffer, because it does not intentionally amplify or attenuate the input signal.

The receive device 222 includes a decoder 256 that reverses the encoding performed by the encoder 230. The decoder 256 uses the scode 254 to identify the encoding scheme implemented by the encoder 230. Then the decoder 256 decodes the data based on the encoding scheme indicated by the scode 254. An output of the decoder 256 is decoded data 228 that should be identical to the encoded data 226 (in terms of digital code, but may be at a different voltage level than the encoded data 226). The decoded data 228 is then provided to a destination electronic component, such as a memory, processing unit, multiplexer, register, or the like.

One or more of the encoder 230, buffer 232, decoder 256, scheme quantifying logic 234, 236, 238, scheme selector 252, or a component thereof can be implemented using electric or electronic components. The electric or electronic components can include one or more transistors, resistors, capacitors, diodes, amplifiers, inductors, multiplexers, logic gates (e.g., AND, OR, XOR, negate, buffer, a combination thereof, or the like), power supplies, oscillators, switches, processing units (e.g., central processing units (CPUs), application specific integrated circuits (ASICs), field programmable gate arrays (FPGAs), graphics processing units (GPUs), or the like), analog to digital converters, digital to analog converters, transducers, transformers, buck or boost converters, a combination thereof, or the like.

Estimates of power benefits with a few schemes are provided here as examples. A purely random data set is assumed.

**Transition power**

A total power reduction with encoding over all possible data combinations is given by Equation 7:

$$\sum_{k=1}^{n} \left\{ \binom{n}{k} \cdot \Delta P_p \cdot \left(p_p\right)^k \cdot k \cdot \sum_{j=0}^{r} \binom{n-k}{j} \ - \ \binom{n}{k} \cdot \Delta P_n \cdot \left(p_p\right)^k \cdot \right.$$

$$\left. \sum_{j=0}^{r} \binom{n-k}{j} \cdot j \cdot p_n^j \right\} \qquad (7)$$

Where, $r = min\,(k - 1, n - k)$; $\Delta P_p$ is the reduction in power for each of the $k$ lanes when the bus is encoded; $\Delta P_n$ is the possible increase in power for each of the remaining $n - k$ lanes when the bus is encoded; $(p_p)^k$, is the probability of $k$ lanes with data transition that would save $\Delta P_p$ upon encoding. The formula can be extended for the case of multiple $\Delta P_p$ and $\Delta P_n$. The 2nd Bit inversion discussed earlier provides an average of 8% power reduction for a bus with n=16 differential pairs for a random data set not accounting for the power consumed by the encoding logic or the extra data line added.

## Termination Power reduction based on logic state

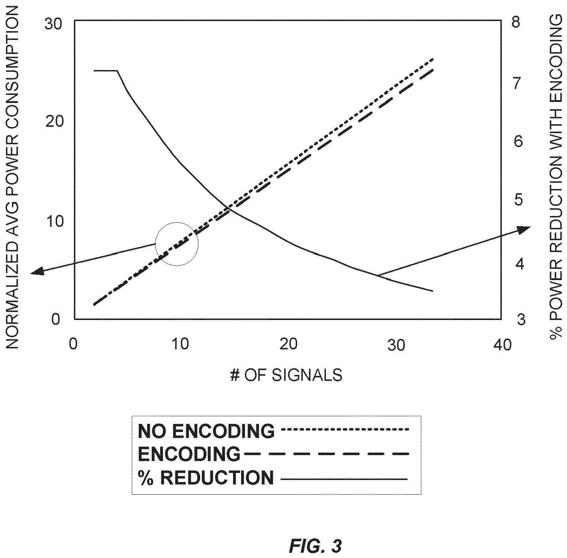

FIG. 3 illustrates, by way of example, a graph of power savings in an I/O using a selectable encoding scheme. In FIG. 3, power consumption without encoding, power consumption with selectable encoding, and percent of reduction in power using encoding are illustrated.

In the estimation provided in FIG. 3, the transition power is neglected. The normalized voltage and power consumption for each of the logic levels is shown in Table 5. The power consumption is maximum when bit $b_1$ is cleared (value = 0) and minimum when bit $b_1$ is set (value = 1). If more than 50% of the lanes have $b_1$ cleared one can potentially reduce the power consumption by inverting the value of bit $b_1$ for every signal.

The average power consumption for an $n$-lane interface without encoding is given by

$$P_{ave} = \sum_{k=0}^{n} \underbrace{\binom{n}{k}\left(\frac{1}{2}\right)^n}_{\substack{probability\ of \\ having\ k\ no.of\ lanes\ with\ b_1=0}} \underbrace{[kP_0 + (n-k)P_1]}_{\substack{power\ consumed \\ when\ k\ no.of\ lanes\ have\ b_1=0}}$$

With bit $b_1$ inversion the average power is modified to:

$$P_{aveDBI} = \sum_{k=0}^{trun(^n/_2)} \binom{n}{k}\left(\frac{1}{2}\right)^n [kP_0 + (n-k)P_1]$$

$$+ \sum_{k=trun(^n/_2)+1}^{n} \binom{n}{k}\left(\frac{1}{2}\right)^n [(n-k)P_0 + kP_1] + P_{DBIsel}$$

Power with and without encoding and the difference are plotted in FIG. 3. A 6% reduction can be realized for an 8-lane bus and ~4.5% reduction for a 16-lane bus, including the power added by the scode signal line itself. Note that the percentage power reduction reduces with bus width so that the scheme is more useful for buses with fewer lanes.

Table 5: Normalized Voltage and Power Per Logic State

| B0 | B1 | Vdiff | Vp | Vn | Pp | Pn | Pdiff |
|----|----|-------|-----|-----|-----|-----|-------|
| 0 | 0 | -1 | 0 | 1 | 0 | 1 | 1 |
| 0 | 1 | -1/3 | 1/3 | 2/3 | 1/9 | 4/9 | 5/9 |
| 1 | 1 | 1/3 | 2/3 | 1/3 | 4/9 | 1/9 | 5/9 |
| 1 | 0 | 1 | 1 | 0 | 1 | 1 | 1 |

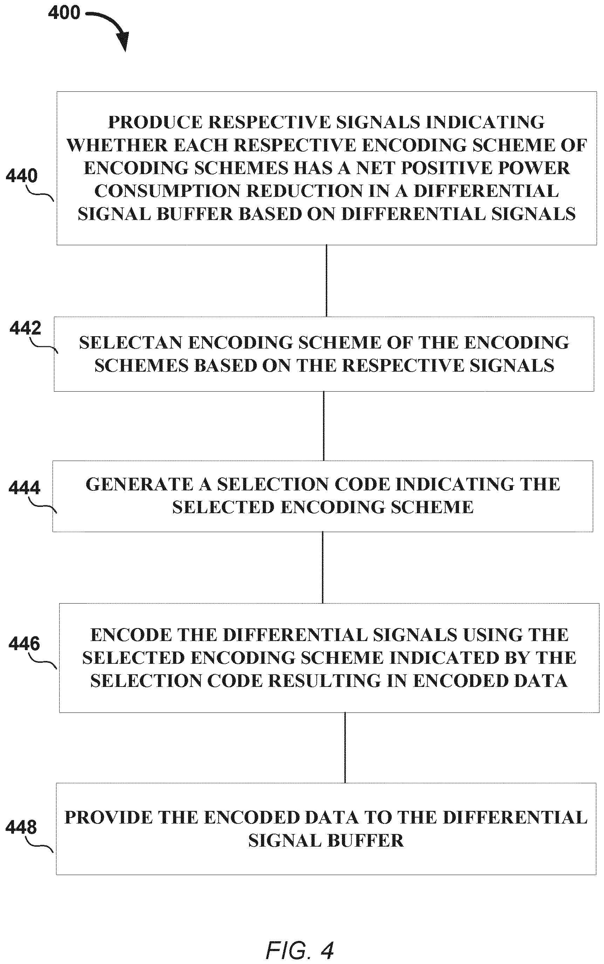

FIG. 4 illustrates, by way of example, a diagram of an embodiment of a method 400 for power consumption reduction in an I/O buffer using a selectable encoding scheme. The method 400 as illustrated includes producing (e.g., by encoding scheme quantifying circuitry 234) respective signals indicating whether each respective encoding scheme of encoding schemes has a net positive power consumption reduction in a differential signal buffer based on differential signals, at operation 440; selecting (e.g., by encoding scheme selection circuitry 252) an encoding scheme of the encoding schemes based on the respective signals, at operation 442; generating (by the encoding scheme selection circuitry 252) a selection code 254 indicating the selected encoding scheme, at operation 444; encoding (e.g., by an encoder 230) the differential signals using the selected encoding scheme indicated by the selection code 254 resulting in encoded data 226, at operation 446; and providing the encoded data 226 to the differential signal buffer 232, at operation 448.

The encoding schemes can include two or more of inverting only a first bit of each differential signal of the differential signals, inverting only a second bit of each differential signal of the differential signals, inverting both bits of each differential signal of the differential signals, or swapping the bits of each differential signal of the differential signals in accord with a table. The method 400 can further include determining (e.g., by the encoding scheme quantifying circuitry 234) an amount to which each of the encoding schemes provides the net positive power reduction. The method 400 can further include selecting (e.g., by the encoding scheme selection circuitry 252) the encoding scheme corresponding to a greatest net positive power reduction.

The method 400 can further include selecting (e.g., by the encoding scheme selection circuitry 252) an encoding scheme of encoding schemes that produces a net positive power consumption reduction and a net positive noise reduction. The method 400 can further include selecting (e.g., by the encoding scheme selection circuitry 252) the encoding scheme based on a weighted net positive power consumption and a weighted net positive noise reduction.

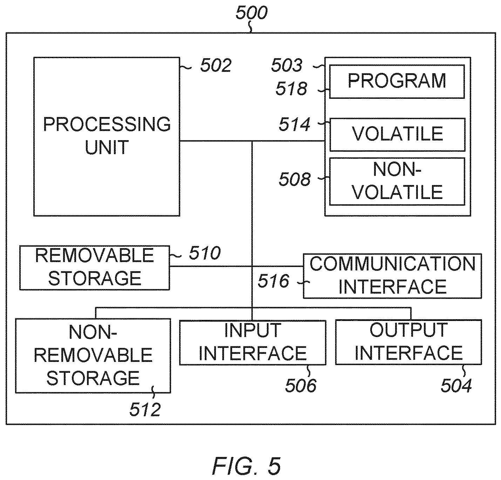

FIG. 5 illustrates, by way of example, a block diagram of an embodiment of a machine 500 (e.g., a computer system) that includes components that can benefit from a selective encoding scheme for a differential signal. One example machine 500 (in the form of a computer), may include a processing unit 502, memory 503, removable storage 510, and non-removable storage 512. Although the example computing device is illustrated and described as machine 500, the computing device may be in different forms in different embodiments. Further, although the various data storage elements are illustrated as part of the machine 500, the storage may also or alternatively include cloud-based storage accessible via a network, such as the Internet.

Memory 503 may include volatile memory 514 and non-volatile memory 508. The machine 500 may include - or have access to a computing environment that includes - a variety of computer-readable media, such as volatile memory 514 and non-volatile memory 508, removable storage 510 and non-removable storage 512. Computer storage includes random access memory (RAM), read only memory (ROM), erasable programmable read-only memory (EPROM) & electrically erasable programmable read-only memory (EEPROM), flash memory or other memory technologies, compact disc read-only memory (CD ROM), Digital Versatile Disks (DVD) or other optical disk storage, magnetic cassettes, magnetic tape, magnetic disk storage or other magnetic storage devices capable of storing computer-readable instructions for execution to perform functions described herein.

The machine 500 may include or have access to a computing environment that includes input 506, output 504, and a communication connection 516. Output 504 may include a display device, such as a touchscreen, that also may serve as an input device. The input 506 may include one or more of a touchscreen, touchpad, mouse, keyboard, camera, one or more device-specific buttons, one or more sensors integrated within or coupled via wired or wireless data connections to the machine 500, and other input devices. The computer may operate in a networked environment using a communication connection to connect to one or more remote computers, such as database servers, including cloud-based servers and storage. The remote computer may include a personal computer (PC), server, router, network PC, a peer device or other common network node, or the like. The communication connection may include a Local Area Network (LAN), a Wide Area Network (WAN), cellular, Institute of Electrical and Electronics Engineers (IEEE) 802.11 (Wi-Fi), Bluetooth, or other networks.

Computer-readable instructions stored on a computer-readable storage device are executable by the processing unit 502 (sometimes called processing circuitry) of the machine 500. A hard drive, CD-ROM, and RAM are some examples of articles including a non-transitory computer-readable medium such as a storage device. For example, a computer program 518 may be used to cause processing unit 502 to perform one or more methods or algorithms described herein.

Note that the term "circuitry" or "circuit" as used herein refers to, is part of, or includes hardware components, such as transistors, resistors, capacitors, diodes, inductors, amplifiers, oscillators, switches, multiplexers, logic gates (e.g., AND, OR, XOR), power supplies, memories, or the like, such as can be configured in an electronic circuit, a logic circuit, a processor (shared, dedicated, or group) and/or memory (shared, dedicated, or group), an Application Specific Integrated Circuit (ASIC), a field-programmable device (FPD) (e.g., a field-programmable gate array (FPGA), a programmable logic device (PLD), a complex PLD (CPLD), a high-capacity PLD (HCPLD), a structured ASIC, or a programmable SoC), digital signal processors (DSPs), etc., that are configured to provide the described functionality. In some embodiments, the circuitry may execute one or more software or firmware programs to provide at least some of the described functionality. The term "circuitry" or "circuit" may also refer to a combination of one or more hardware elements (or a combination of circuits used in an electrical or electronic system) with the program code used to carry out the functionality of that program code. In these embodiments, the combination of hardware elements and program code may be referred to as a particular type of circuitry.

The term "processor circuitry", "processing circuitry", "processing unit", or "processor" as used herein thus refers to, is part of, or includes circuitry capable of sequentially and automatically carrying out a sequence of arithmetic or logical operations, or recording, storing, and/or transferring digital data. These terms may refer to one or more application processors, one or more baseband processors, a physical central processing unit (CPU), a single- or multi-core processor, and/or any other device capable of executing or otherwise operating computer-executable instructions, such as program code, software modules, and/or functional processes.

Additional Notes and Examples

Example 1 includes a device for selecting a differential signal encoding scheme. The device can include a differential signal buffer and encoding scheme quantifying and selection circuitry. The encoding scheme quantifying and selection circuitry can be configured to generate a selection code indicating a selected encoding scheme of the encoding schemes based on respective signals indicating whether each respective encoding scheme of encoding schemes has a net positive power consumption reduction in differential signals. The encoding scheme quantifying and selection circuitry can be configured to provide the selection code to an encoder.

In Example 2, Example 1 can further include the encoder. The encoder can be configured to encode the differential signals using the selected encoding scheme indicated by the selection code resulting in encoded data.

In Example 3, the encoder of Example 2 is further configured to provide the encoded data to the differential signal buffer.

In Example 4, the encoding schemes of at least one of Examples 1-3 further includes two or more of inverting only a first bit of each differential signal of the differential signals, inverting only a second bit of each differential signal of the differential signals, inverting both the first and second bits of each differential signal of the differential signals, or swapping the bits of each differential signal of the differential signals in accord with a table.

In Example 5 the encoding scheme quantifying and selection circuitry of at least one of Examples 1-4 determines an amount of net positive power reduction which each of the encoding schemes provides.

In Example 6, the encoding scheme quantifying and selection circuitry of Example 5 selects the encoding scheme corresponding to a greatest net positive power reduction.

In Example 7, the encoding scheme quantifying and selection circuitry of at least one of Examples 1-6 is further configured to select an encoding scheme of encoding schemes that produces a net positive power consumption reduction and a net positive noise reduction.

In Example 8, the encoding scheme quantifying and selection circuitry of Example 7 selects the encoding scheme based on a weighted net positive power consumption and a weighted net positive noise reduction.

Example 9 includes a system for selecting a differential signal encoding scheme. The system can include a transmit device comprising a differential signal buffer, encoding scheme quantifying and selection circuitry, and an encoder. The encoding scheme quantifying and selection circuitry can receive differential signals and produce respective signals indicating whether each respective encoding scheme of encoding schemes has a net positive power consumption reduction on the differential signals. The encoding scheme quantifying and selection circuitry can select an encoding scheme of the encoding schemes based on the respective signals. The encoding scheme quantifying and selection circuitry can generate a selection code indicating the selected encoding scheme. The encoder can be configured to receive the selection code and the differential signals. The encode can encode the differential signals using the selected encoding scheme indicated by the selection code resulting in encoded data. The encoder can provide the encoded data and the selection code to the differential signal buffer.

In Example 10, Example 9 further includes a receiver comprising a decoder configured to receive the selection code and the encoded data, and decode the encoded data based on the selection code.

In Example 11, the encoding schemes of at least one of Examples 9-10 includes two or more of inverting only a first bit of each differential signal of the differential signals, inverting only a second bit of each differential signal of the differential signals, inverting both bits of each differential signal of the differential signals, or swapping the bits of each differential signal of the differential signals in accord with a table.

In Example 12, the encoding scheme quantifying and selection circuitry of at least one of Examples 9-11 determines an amount of net positive power reduction which each of the encoding schemes provides.

In Example 13, the encoding scheme quantifying and selection circuitry of Example 12 selects the encoding scheme corresponding to a greatest net positive power reduction.

In Example 14, the encoding scheme quantifying and selection circuitry of at least one of Examples 9-13 is further configured to select an encoding scheme of encoding schemes that produces a net positive power consumption reduction and a net positive noise reduction.

In Example 15, the encoding scheme quantifying and selection circuitry of Example 14 selects the encoding scheme based on a weighted net positive power consumption and a weighted net positive noise reduction.

Example 16 includes a device for selecting a differential signal encoding scheme, the device comprising means for producing respective signals indicating whether each respective encoding scheme of encoding schemes has a net positive power consumption reduction in a differential signal buffer based on differential signals. The device can further comprise means for selecting an encoding scheme of the encoding schemes based on the respective signals. The device can further comprise means for generating a selection code indicating the selected encoding scheme. The device can further comprise means for encoding the differential signals using the selected encoding scheme indicated by the selection code resulting in encoded data. The device can further comprise means for providing the encoded data to the differential signal buffer.

In Example 17, the encoding schemes of Example 16 include two or more of inverting only a first bit of each differential signal of the differential signals, inverting only a second bit of each differential signal of the differential signals, inverting both bits of each differential signal of the differential signals, or swapping the bits of each differential signal of the differential signals in accord with a table.

In Example 18, at least one of Examples 16-17, further includes means for determining an amount to which each of the encoding schemes provides the net positive power reduction.

In Example 19, Example 18 further includes means for selecting the encoding scheme corresponding to a greatest net positive power reduction.

In Example 20, at least one of Examples 16-19 further includes means for selecting an encoding scheme of encoding schemes that produces a net positive power consumption reduction and a net positive noise reduction.

Although an embodiment has been described with reference to specific example embodiments, it will be evident that various modifications and changes may be made to these embodiments without departing from the broader scope of the present disclosure. Accordingly, the specification and drawings are to be regarded in an illustrative rather than a restrictive sense. The accompanying drawings that form a part hereof show, by way of illustration, and not of limitation, specific embodiments in which the subject matter may be practiced. The embodiments illustrated are described in sufficient detail to enable those skilled in the art to practice the teachings disclosed herein. Other embodiments may be utilized and derived therefrom, such that structural and logical substitutions and changes may be made without departing from the scope of this disclosure. This Detailed Description, therefore, is not to be taken in a limiting sense, and the scope of various embodiments is defined only by the appended claims, along with the full range of equivalents to which such claims are entitled.

The subject matter may be referred to herein, individually and/or collectively, by the term "embodiment" merely for convenience and without intending to voluntarily limit the scope of this application to any single inventive concept if more than one is in fact disclosed. Thus, although specific embodiments have been illustrated and described herein, it should be appreciated that any arrangement calculated to achieve the same purpose may be substituted for the specific embodiments shown. This disclosure is intended to cover any and all adaptations or variations of various embodiments. Combinations of the above embodiments, and other embodiments not specifically described herein, will be apparent to those of skill in the art upon reviewing the above description.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, UE, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

The Abstract of the Disclosure is provided to comply with 37 C.F.R. § 1.72(b), requiring an abstract that will allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the Detailed Description, with each claim standing on its own as a separate embodiment.

**Claims**

1. A device for selecting a differential signal encoding scheme, the device comprising:

    a differential signal buffer;
    encoding scheme quantifying and selection circuitry configured to:

    generate a selection code indicating a selected encoding scheme of the encoding schemes based on respective signals indicating whether each respective encoding scheme of encoding schemes has a net positive power consumption reduction in differential signals; and
    provide the selection code to an encoder.

**2.** The device of claim 1, further comprising the encoder, the encoder configured to:
encode the differential signals using the selected encoding scheme indicated by the selection code resulting in encoded data.

**3.** The device of claim 2, wherein the encoder is further configured to provide the encoded data to the differential signal buffer

**4.** The device of one of claims 1-3, wherein the encoding schemes include two or more of inverting only a first bit of each differential signal of the differential signals, inverting only a second bit of each differential signal of the differential signals, inverting both the first and second bits of each differential signal of the differential signals, or swapping the bits of each differential signal of the differential signals in accord with a table.

**5.** The device of one of claims 1-3, wherein the encoding scheme quantifying and selection circuitry determines an amount of net positive power reduction which each of the encoding schemes provides.

**6.** The device of claim 5, wherein the encoding scheme quantifying and selection circuitry selects the encoding scheme corresponding to a greatest net positive power reduction.

**7.** The device of one of claims 1-3, wherein the encoding scheme quantifying and selection circuitry is further configured to select an encoding scheme of encoding schemes that produces a net positive power consumption reduction and a net positive noise reduction.

**8.** The device of claim 7, wherein the encoding scheme quantifying and selection circuitry selects the encoding scheme based on a weighted net positive power consumption and a weighted net positive noise reduction.

**9.** A system for selecting a differential signal encoding scheme, the system comprising:
a transmit device comprising:

   a differential signal buffer;
   encoding scheme quantifying and selection circuitry configured to:

      receive differential signals;
      produce respective signals indicating whether each respective encoding scheme of encoding schemes has a net positive power consumption reduction on the differential signals;
      select an encoding scheme of the encoding schemes based on the respective signals; and
      generate a selection code indicating the selected encoding scheme; and

   an encoder configured to:

      receive the selection code and the differential signals;
      encode the differential signals using the selected encoding scheme indicated by the selection code resulting in encoded data; and
      provide the encoded data and the selection code to the differential signal buffer.

**10.** The system of claim 9, further comprising:
a receiver comprising:
a decoder configured to:

   receive the selection code and the encoded data; and
   decode the encoded data based on the selection code.

**11.** The system of claim 10, wherein the encoding schemes include two or more of inverting only a first bit of each differential signal of the differential signals, inverting only a second bit of each differential signal of the differential signals, inverting both bits of each differential signal of the differential signals, or swapping the bits of each differential signal of the differential signals in accord with a table.

**12.** The system of one of claims 9-11, wherein the encoding scheme quantifying and selection circuitry determines an amount of net positive power reduction which each of the encoding schemes provides.

13. The system of claim 12, wherein the encoding scheme quantifying and selection circuitry selects the encoding scheme corresponding to a greatest net positive power reduction.

14. The system of one of claims 9-11, wherein the encoding scheme quantifying and selection circuitry is further configured to select an encoding scheme of encoding schemes that produces a net positive power consumption reduction and a net positive noise reduction.

15. The system of claim 14, wherein the encoding scheme quantifying and selection circuitry selects the encoding scheme based on a weighted net positive power consumption and a weighted net positive noise reduction.

FIG. 1

*FIG. 2*

FIG. 3

400

```
┌─────────────────────────────────────────────────────┐
│            PRODUCE RESPECTIVE SIGNALS INDICATING      │
│       WHETHER EACH RESPECTIVE ENCODING SCHEME OF      │
│  440  ENCODING SCHEMES HAS A NET POSITIVE POWER       │
│       CONSUMPTION REDUCTION IN A DIFFERENTIAL         │
│       SIGNAL BUFFER BASED ON DIFFERENTIAL SIGNALS     │
└─────────────────────────────────────────────────────┘
```

442

```
┌─────────────────────────────────────────────────────┐
│       SELECT AN ENCODING SCHEME OF THE ENCODING       │
│        SCHEMES BASED ON THE RESPECTIVE SIGNALS        │
└─────────────────────────────────────────────────────┘
```

444

```
┌─────────────────────────────────────────────────────┐
│        GENERATE A SELECTION CODE INDICATING THE       │
│              SELECTED ENCODING SCHEME                 │
└─────────────────────────────────────────────────────┘
```

446

```
┌─────────────────────────────────────────────────────┐
│       ENCODE THE DIFFERENTIAL SIGNALS USING THE       │
│      SELECTED ENCODING SCHEME INDICATED BY THE        │
│     SELECTION CODE RESULTING IN ENCODED DATA          │
└─────────────────────────────────────────────────────┘
```

448

```
┌─────────────────────────────────────────────────────┐
│   PROVIDE THE ENCODED DATA TO THE DIFFERENTIAL        │
│                  SIGNAL BUFFER                        │
└─────────────────────────────────────────────────────┘
```

*FIG. 4*

FIG. 5

Europäisches
Patentamt

European
Patent Office

Office européen
des brevets

# EUROPEAN SEARCH REPORT

**Application Number**

EP 23 21 7621

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 861 508 B1 (MATHUR SHIV [IN] ET AL) 8 December 2020 (2020-12-08) * figures 1, 5, 6 * * column 4 - column 11 * ----- | 1-15 | INV. H04L25/02 H04L25/49 |

**TECHNICAL FIELDS SEARCHED (IPC)**

H04L

The present search report has been drawn up for all claims

| Place of search | Date of completion of the search | Examiner |
|---|---|---|
| Munich | 22 May 2024 | Baltersee, Jens |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 21 7621

This annex lists the patent family members relating to the patent documents cited in the above-mentioned European search report.
The members are as contained in the European Patent Office EDP file on
The European Patent Office is in no way liable for these particulars which are merely given for the purpose of information.

22-05-2024

| Patent document cited in search report | Publication date | Patent family member(s) | Publication date |
|---|---|---|---|
| US 10861508 B1 | 08-12-2020 | NONE | |

EPO FORM P0459